# FASCICULE DE BREVET EUROPEEN

(11) **EP 1 976 360 B1**
(45) Date de publication et mention de la délivrance du brevet: **08.05.2019**
(21) Numéro de dépôt: 08103101.5
(22) Date de dépôt: 28.03.2008
(51) Int. Cl.: F24F 11/00, F24F 110/10, H05K 7/20, F24F 13/12, F24F 13/068, F24F 13/10, F24F 11/76

(54) **Systeme de climatisation d'une piece**
Klimatisierungssystem für ein Zimmer
Air-conditioning system for a room

(30) Priorité: 30.03.2007 FR 0754195
(43) Date de publication de la demande: 01.10.2008
(73) Titulaire: Data 4, 75008 Paris (FR)
(72) Inventeur: SERINET, Gilles, 92500, RUEIL MALMAISON (FR)
(74) Mandataire: Regimbeau

(56) Documents cités:
- WO-A-02/12797
- WO-A-2004/051156
- JP-A- 61 072 946
- US-A- 5 014 608
- US-A1- 2006 086 119

## Description

L'invention concerne les systèmes de climatisation, et ses supports et élément terminaux.

L'invention concerne plus particulièrement les systèmes de climatisation par plafond, destinés à ajuster la température d'une pièce à une consigne de température donnée, par envoi d'air froid ou chaud dans la pièce.

L'invention trouve une application particulièrement intéressante dans le refroidissement de pièces logeant des moyens informatiques, telles que les salles informatiques des centres d'hébergement de données (également appelés « data centres »). En effet, elles nécessitent généralement d'être maintenues à une température ne dépassant pas une température seuil déterminée, pour ne pas risquer l'endommagement des équipements informatiques ou réseaux qui y sont entreposés. Or, ces équipements informatiques ou réseaux, qui fonctionnent en continu, chauffent et font inévitablement croître la température de la salle.

Des systèmes de climatisation sont donc nécessaires. Le système le plus couramment utilisé dans une telle situation est un système de climatisation placé sous un faux-plancher composé de dalles perforées ou équipées de grilles, qui projette de l'air froid à travers les perforations des dalles, en direction du plafond. L'air projeté permet ainsi de maintenir la température de la pièce à une consigne de température donnée, en accompagnant l'air chaud ascendant.

Ce système de climatisation présente cependant de nombreux inconvénients.

Parmi eux, l'impossibilité de réguler de manière homogène la température au sein de la pièce se révèle particulièrement gênante. En effet, l'air soufflé à travers les dalles du sol est destiné à être uniformément diffusé dans la pièce, mais son passage est entravé par des câbles de branchement, qui sont généralement placés sous le plancher pour des questions de commodité. Ainsi, non seulement le refroidissement de la pièce n'est pas réalisé de manière optimale, mais il se fait en outre indépendamment des gradients thermiques présents dans le volume à refroidir. Or, il est connu qu'une salle informatique d'un centre de traitement de données possède un gradient thermique important, dû notamment aux différents matériels informatiques en fonctionnement.

Par ailleurs, le remplacement ou le changement de branchement d'un ou de plusieurs câbles, tout comme l'accès à des éléments défectueux du système de climatisation (gêné par la présence des câbles), nécessitent le démontage du faux-plancher. Les opérations de maintenance sont donc lourdes à mettre en oeuvre et coûteuses, notamment lorsque la pièce est occupée par les moyens informatiques, qu'il faut alors déplacer.

En outre, ce système est très sensible à l'accumulation de poussière, que l'on ne peut empêcher, étant donnée la localisation du système, et les câbles faisant obstacle à tout nettoyage. Or, la poussière empêche en partie le passage de l'air et réduit donc encore davantage l'efficacité du système de climatisation, ce qui peut, à nouveau, porter préjudice aux installations informatiques.

Enfin le faux-plancher doit supporter le poids des matériels logés par la pièce, ce qui constitue une contrainte exigeante pour son dimensionnement et requière un coût de fabrication élevé.

De nouveaux systèmes de climatisation ont donc été développés afin de tenter de pallier des inconvénients de la technique antérieure. Le document WO 99/0411, par exemple, propose de placer des moyens de climatisation dans un faux-plafond comprenant des plaques acoustiques poreuses, le faux-plafond étant situé à distance du plafond de la pièce à réguler en température. L'air envoyé par une soufflerie circule entre le plafond et le faux-plafond, et est chassé au travers des porosités des plaques par application d'une pression. Toutefois, ce système ne permet pas d'adapter la climatisation aux gradients thermiques de la pièce, et ne propose pas de solutions aux problèmes de maintenance et d'entretien posés par la présence de câbles sous un faux-plancher. Par ailleurs, il ne peut être mis en oeuvre pour refroidir une salle informatique d'un centre d'hébergement de données : l'air diffusé par les pores ne peut suffire en effet pour compenser l'augmentation de température due au fonctionnement des processeurs.

Le document WO2004051156 divulgue un système de climatisation selon le préambule de la revendication 1.

Un objectif de l'invention est donc de pallier à ces inconvénients de la technique antérieure, en proposant un système de climatisation apte à refroidir une salle informatique d'un centre d'hébergement de données.

Un autre objet de l'invention est de proposer un système de climatisation apte à réguler la diffusion de l'air en fonction de gradients thermiques de la pièce dans laquelle il est installé.

Un autre objet de l'invention est de proposer un système de climatisation assurant le maintien de la température de la pièce selon une consigne de température en toutes circonstances.

Un autre objet de l'invention est de proposer un système de climatisation dont la maintenance est facilitée par rapport aux systèmes conventionnels.

Un autre objet de l'invention est de proposer un système de climatisation dont les opérations d'entretien sont facilitées par rapport aux systèmes conventionnels.

Enfin, un objectif est de proposer une pièce logeant des moyens informatiques, équipée d'un système de climatisation selon l'invention, dans laquelle les câbles ne constituent pas une gêne pour l'entretien et la maintenance générale.

Pour cela, l'invention propose un système de climatisation d'une pièce, comprenant des moyens pour diffuser de l'air dans la pièce et des moyens de réglage de la diffusion de l'air soufflé, caractérisé en ce que lesdits moyens sont destinés à être placés au niveau du plafond de la pièce, et en ce que les moyens de réglage sont aptes à moduler spatialement la diffusion de l'air dans la pièce.

Selon l'invention, lesdits moyens pour diffuser l'air sont des ouvertures pratiquées dans le faux-plafond, à distance du plafond de la pièce.

Certains aspects préférés mais non limitatifs sont les suivants :
- les ouvertures ont une géométrie oblongue, circulaire ou rectangulaire,
- la modulation spatiale, par les moyens de réglage du flux d'air diffusé est effectuée par modification de la taille des ouvertures,
- les moyens de réglage comprennent au moins deux grilles superposées, qui forment le faux-plafond, et dans lesquelles sont pratiquées les ouvertures,
- la modification de la taille des ouvertures est réalisée par déplacement d'une grille par rapport à l'autre,
- la taille des ouvertures est réalisée au moyen d'un diaphragme,
- la modification de la taille des ouvertures est effectuée de manière sélective,
- la modification de la taille des ouvertures est effectuée par groupement d'ouvertures,
- chaque groupement comprend un ensemble d'au moins une ouverture,
- les ouvertures d'un même groupement sont adjacentes,
- chaque groupement définit une zone du plafond,
- il comprend en outre des moyens de blocage en position des moyens de réglage,
- les moyens de blocage sont des molettes,
- il comprend en outre des moyens de récupération de l'air insufflé,
- les moyens de récupération sont destinés à être placés en partie basse de la pièce,
- les moyens de récupération sont destinés à être placés dans une paroi latérale de la pièce,
- les moyens de récupération de l'air comprennent des filtres à air pour filtrer l'air récupéré,
- des moyens de détection d'incendie sont placés au niveau des moyens de récupération de l'air,
- il comprend en outre des moyens de gestion de l'humidité de la pièce,
- les moyens de réglage sont contrôlés manuellement,
- les moyens de réglage sont contrôlés par des moyens de commande en fonction d'une consigne de température,
- l'air diffusé est mis en pression entre le plafond et le sous-plafond,
- il comprend en outre au moins une centrale de climatisation,
- la centrale de climatisation est connectée en amont à des groupes froids,
- la centrale de climatisation est connectée en aval à une soufflerie,
- la soufflerie envoie l'air entre le faux-plafond et le plafond,
- il comprend en outre au moins une grille à ailettes,
- l'air envoyé par la soufflerie est dévié par la grille à ailettes, de sorte que l'air soit réparti uniformément entre le plafond et le faux-plafond, et balaye toute la surface du faux-plafond.

Selon un deuxième aspect de l'invention, on propose une pièce logeant du matériel informatique, caractérisée en ce qu'elle comprend un système de climatisation selon l'une des revendications précédentes.

Certains aspects préférés mais non limitatifs sont les suivants :
- les chemins de câble sont placés au niveau du plafond,
- les chemins de câble sont placés sous le faux-plafond,
- chaque chemin de câble est dédié à un réseau,
- elle comprend un chemin de câble dédié à chaque élément parmi le groupe suivant : les courants forts, les courants faibles, et les réseaux de fibres optiques.

D'autres caractéristiques, buts et avantages de la présente invention apparaîtront à la lecture de la description détaillée qui va suivre, au regard des dessins annexés, donnés à titre d'exemples non limitatifs et sur lesquels :
- La figure 1 illustre une pièce en coupe munie d'un système de climatisation selon l'invention,
- La figure 2a présente des moyens de diffusion du système de climatisation selon un premier mode de réalisation, dans une première position de diffusion,
- La figure 2b présente des moyens de diffusion du système de climatisation selon le premier mode de réalisation, dans une deuxième position de diffusion,
- La figure 2c présente des moyens de diffusion du système de climatisation selon le premier mode de réalisation, dans une troisième position de diffusion,
- La figure 2d présente des moyens de diffusion du système de climatisation selon le premier mode de réalisation, dans une quatrième position de diffusion,
- La figure 3a présente des moyens de diffusion du système de climatisation selon un deuxième mode de réalisation, dans une première position de diffusion,
- La figure 3b présente des moyens de diffusion du système de climatisation selon le deuxième mode de réalisation, dans une deuxième position de diffusion,
- La figure 3c présente des moyens de diffusion du système de climatisation selon le deuxième mode de réalisation, dans une troisième position de diffusion.

Le système de climatisation selon l'invention comprend des moyens 2 de diffusion, ainsi que des moyens de réglage du flux d'air envoyé dans la pièce 1 par les moyens 2 de diffusion.

Les moyens de diffusion sont de préférence des ouvertures 2 pratiquées dans un faux-plafond 3. Le faux-plafond 3 est destiné à être placé à distance du plafond 4a de la pièce 1, de manière à laisser un espace 5 libre de passage à de l'air.

Le flux d'air 6 est envoyé par une soufflerie, située en amont des moyens 2 de diffusion, vers l'espace 5. Pour assurer une répartition homogène de l'air dans cet espace 5, au moins une grille à ailettes 7 est placée à l'entrée de l'espace 5, et dévie le flux d'air 6. Le flux suit alors une direction A parallèle au plafond 4a et au faux-plafond 3, et est donc réparti de manière à balayer, de façon homogène dans l'espace 5, toute la surface du faux-plafond 3.

La mise en pression de l'air par la soufflerie fait alors passer l'air au travers des ouvertures 2 pratiquées dans le faux-plafond 3, selon la direction B, vers l'intérieur de la pièce 1.

L'air est ensuite aspiré par des moyens de récupération 20, placés de préférence près du sol 4c, dans une paroi latérale 4b de la pièce 1, pour permettre un refroidissement optimal de la pièce 1 en favorisant la circulation de l'air insufflé. Ces moyens de récupération 20 aspirent l'air insufflé, dont la température a augmenté au cours de sa circulation dans la pièce 1, et le chassent en dehors de la pièce 1. L'air chassé est alors rejeté à l'extérieur, ou recyclé puis réutilisé par le système de climatisation si celui-ci fonctionne en système fermé ou semi-fermé.

Les moyens de récupération 20 peuvent comprendre en outre des moyens pour filtrer l'air récupéré. On peut également prévoir des moyens de détection d'incendie conventionnels placés devant les moyens de récupération 20, qui détectent la présence de fumée dans l'air lorsqu'il est aspiré, et des moyens de gestion de l'humidité de la pièce.

Les moyens de réglage du flux d'air insufflé dans la pièce 1 sont aptes à moduler spatialement la diffusion du flux d'air dans la pièce 1, en modifiant de manière sélective la taille des ouvertures 2.

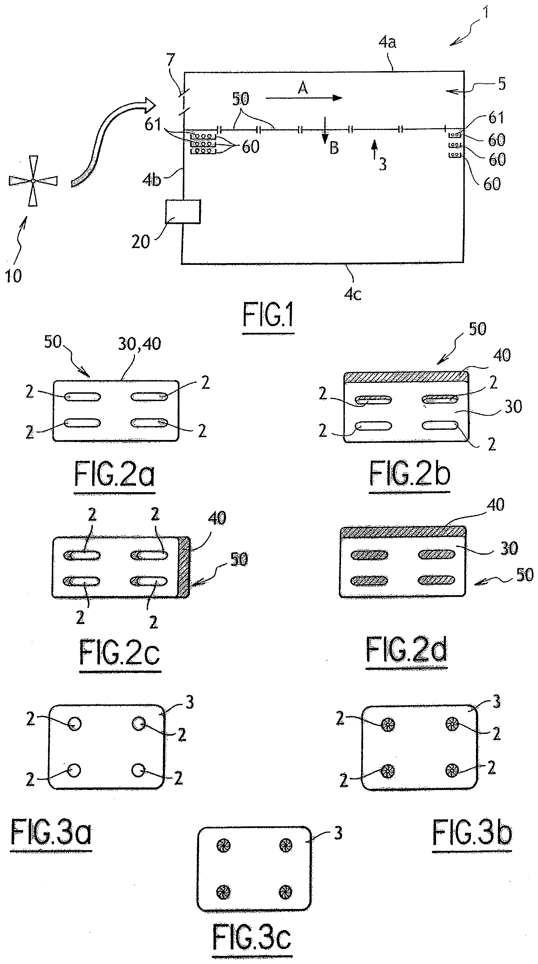

De préférence, les ouvertures 2 sont des perforations pratiquées dans le faux-plafond 3. Les moyens de réglage sont alors des moyens d'obturation partielle (comme illustré sur les figures 2b, 2c et 3b annexées) ou totale (comme illustré sur les figures 2d et 3c annexées) des sections libres des perforations 2, contrôlables individuellement au niveau de chaque perforation, ou par groupement de perforations.

Les groupements de perforations sont par exemple un ensemble de perforations 2 adjacentes, le nombre de perforations 2 composant un tel groupement dépendant de l'échelle de modulation spatiale désirée pour la régulation de la température. Les groupements comprennent un nombre moins important de perforations si l'on souhaite moduler finement la régulation du flux, que si l'on veut simplement adapter la diffusion à un faible gradient de température dans la pièce.

Le réglage des sections libres peut être réalisé manuellement, ou grâce à un moyen de commande électrique, en fonction d'une consigne de température. Le cas échéant, des capteurs de température sont placés dans la pièce 1 et délivrent un signal représentatif du gradient thermique de la pièce 1, de sorte que les moyens de commande contrôlent la section libre des perforations 2 en fonction des informations transmises par lesdits capteurs, et de la consigne de température enregistrée.

Selon une forme de réalisation préférée, illustrée sur les figures 2a à 2d, le faux-plafond est constitué d'au moins deux grilles 30 et 40, superposées l'une sur l'autre, dans lesquelles sont pratiquées les perforations. Les perforations sont de préférence de taille et de forme identiques, et réparties uniformément dans le plan de chaque grille 30, 40 du faux-plafond 3, de sorte qu'il soit possible de placer chaque perforation d'une grille 30 en face d'une perforation pratiquée dans l'autre grille 40 pour former des ouvertures 2 reliant l'espace 5 au-dessus du faux-plafond 3 et la pièce 1.

Chaque grille 30, 40 est de taille et de forme quelconque. De préférence, deux grilles 30, 40 superposées l'une sur l'autre sont identiques.

Dans la suite de la description, nous qualifierons l'ensemble formé par deux grilles perforées 30, 40 et superposées de panneau. Nous désignerons par ailleurs ce panneau par la référence 50 sur les dessins annexés.

De préférence, le faux-plafond 3 comprend une pluralité de panneaux 50 adjacents du type précité, couvrant l'ensemble de la surface du plafond 4a, ou du moins une majeure partie.

Lorsque les perforations 2 des grilles 30 et 40, qui forment chaque panneau 50, sont en vis-à-vis, comme illustré sur la figure 2a, la partie du faux-plafond 3 couverte par le panneau 50 présente une série d'ouvertures 2 par lesquelles l'air peut passer librement. Et lorsque les grilles 30 et 40 sont décalées transversalement ou longitudinalement l'une par rapport à l'autre, les ouvertures 2 ont une taille réduite, comme illustré sur les figures 2b et 2c, voire nulle, comme illustré sur la figure 2d : le flux d'air pouvant traverser est donc réduit.

On peut donc moduler spatialement la diffusion du flux d'air envoyé dans la pièce 1 par zones, en jouant sur la section libre des ouvertures 2 au niveau de chaque panneau 50 selon la température désirée dans la partie sous-jacente de la pièce 1. La surface des zones régulées est égale alors à la surface des panneaux 50 constituant le faux-plafond 3.

Dans ce mode de réalisation, les perforations 2 ont une géométrie quelconque, par exemple rectangulaire ou circulaire.

De préférence, les perforations sont de géométrie oblongue, pour éviter tout problème de singularité (due à la présence d'angles, comme ce peut être le cas avec des ouvertures rectangulaires), et pouvoir réguler plus précisément et plus facilement l'air diffusé. En effet, dans le cas de perforations circulaires, le déplacement d'une grille 30 par rapport à l'autre 40 entraînerait une variation irrégulière de la section libre des perforations, et donc de la quantité de flux envoyée dans la pièce, tandis qu'une géométrie oblongue autorise une modification plus linéaire.

Le positionnement respectif des grilles 30 et 40 peut-être effectué manuellement. Dans ce cas, les grilles 30 et 40 d'un panneau 50 sont déplacées l'une par rapport à l'autre jusqu'à ce que les ouvertures 2 présentent la taille voulue. On peut alors maintenir les grilles 30 et 40 superposées en position, pour éviter toute variation indésirable de leurs sections libres, qui changerait le réglage de la diffusion de l'air, en les bloquant au moyen de molettes.

Le positionnement des grilles 30 et 40 peut également être effectué grâce à des moyens de commande électriques, qui déplacent les grilles 30 et 40 l'une par rapport à l'autre, en fonction du gradient thermique de la pièce 1, et de la consigne de température.

Selon une deuxième forme de réalisation, illustré sur les figures 3a à 3c, chaque ouverture 2 pratiquée dans le faux-plafond est associée à un diaphragme 60, qui permet d'en modifier la taille.

Ainsi, dans le cas d'ouvertures circulaires, le diaphragme est-il particulièrement adapté pour moduler le flux d'air diffusé dans la pièce, ce dernier modifiant simplement le diamètre de l'ouverture circulaire. Le réglage peut donc être aisément contrôlé.

De préférence, l'obturation des ouvertures 2 au moyen du diaphragme est contrôlée par des moyens de commande asservis à une consigne de température donnée. Elle peut à nouveau être réalisée par groupement d'ouvertures dans le faux-plafond 3, ces groupements définissant alors des zones de réglage, ou individuellement, au niveau de chaque ouverture.

Lorsque le système de climatisation est installé dans une pièce 1 logeant des moyens informatiques, telle qu'une salle informatique d'un centre de traitement de données, la soufflerie 10 est reliée à au moins une centrale de climatisation, de référence plusieurs, et envoie l'air froid vers les grilles à ailettes 7 avec un débit de l'ordre de 27 km³.h⁻¹. L'air est ainsi projeté à grande vitesse dans l'espace 5, formé entre le plafond 4a et le faux-plafond 3, ce qui d'une part assure sa bonne répartition dans l'espace 5 avant sa diffusion dans la pièce 1, et d'autre part augmente la pression appliquée par l'air sur le faux-plafond 3, et donc la puissance de diffusion du flux d'air à travers les ouvertures 2.

A titre indicatif, pour une salle informatique de centre de traitement de donnée conventionnelle, ayant une surface au sol d'environ 400 m², refroidie au moyen de six centrales de climatisation conventionnels par le système de climatisation selon l'invention :
- la panne d'une centrale de climatisation ne modifie pas substantiellement la température de la pièce 1,
- la panne simultanée de deux centrales de climatisation entraîne une hausse de 2°C de la température de la pièce 1 par rapport à la consigne de température,
- la panne simultanée de trois centrales de climatisation entraîne une hausse de 4°C de la température de la pièce 1 par rapport à la consigne de température.
- Au-delà, la hausse n'est pas acceptable, sous peine d'endommagement du matériel informatique. Toutefois, une telle situation, où plus de la moitié des centrales de climatisation n'est pas opérationnelle, a peu de risques de survenir de nos jours.

En amont des centrales de climatisation, des groupes froids produisent l'eau froide envoyée aux centrales de climatisation.

Enfin, pour des questions de commodité, les câbles de branchement 71 peuvent être acheminés dans des chemins de câbles 70 placés en hauteur dans la pièce 1, de préférence sous le faux-plafond 3, chaque chemin de câble 71 étant spécifique au type de câble acheminé. On peut ainsi acheminer séparément, par exemple, les courants forts, les courants faibles et les réseaux de fibres optiques dans trois chemins de câbles séparés. Les installations sont alors apparentes et donc mieux contrôlées.

Comme le système de climatisation est placé en hauteur, dans le faux-plafond 3 (dimensionné de manière à supporter les contraintes appliquées par l'air soufflé dans la pièce 1, ainsi que le poids du faux plafond 3 et, le cas échéant, du dispositif de contrôle et de déplacement des panneaux 50 qui le constituent), on résout alors les problèmes liés au faux-plancher, devenu inutile, en facilitant les opérations de maintenance et d'entretien (nettoyage), aucune opération lourde, telle que le démontage de dalles, n'étant nécessaire.

Bien évidemment, le système de climatisation selon l'invention n'est pas limité au refroidissement de pièces logeant des moyens informatiques, telles que les salles informatiques des centres d'hébergement de données. Il peut également être adapté au refroidissement et/ou au chauffage de pièces plus conventionnelles.

Par ailleurs, grâce au système climatisation, on peut diffuser de manière réglable de l'air dans la pièce équipée du système en faisant varier la taille des ouvertures pratiquées dans le faux plafond :
- soit afin que la température de la pièce soit homogène, malgré des sources de chaleur ponctuelles (cas des salles informatiques des centres d'hébergement de données). La consigne de température est alors une température constante dans la pièce,
- soit afin de créer un gradient thermique au sein d'une même pièce (cas par exemple d'un bureau « open space » - c'est-à-dire en espace ouvert - dans lequel on souhaite maintenir des températures différentes selon les endroits de la pièce, pour des questions de confort du personnel, afin d'adapter les conditions de travail de chacun à ses besoins). La consigne de température est alors un gradient de température.

## Revendications

1. Système de climatisation d'une pièce (1), comprenant des moyens (2) pour diffuser de l'air dans la pièce (1) et des moyens (30, 40, 60) de réglage de la diffusion de l'air soufflé aptes à moduler spatialement la diffusion de l'air dans la pièce,
**caractérisé en ce que** lesdits moyens (2 ; 30, 40, 60) sont destinés à être placés dans un faux-plafond (3), à distance du plafond (4a) de la pièce (1), et **en ce que** les moyens (2) pour diffuser l'air sont des ouvertures pratiquées dans le faux-plafond (3).

2. Système de climatisation selon la revendication 1, **caractérisé en ce que** les ouvertures (2) ont une géométrie oblongue, circulaire ou rectangulaire.

3. Système de climatisation selon l'une des revendications 1 ou 2, **caractérisé en ce que** la modulation spatiale, par les moyens (30, 40, 60) de réglage du flux d'air diffusé est effectuée par modification de la taille des ouvertures (2).

4. Système de climatisation selon l'une des revendications 1 à 3, **caractérisé en ce que** les moyens de réglage comprennent au moins deux grilles (30, 40) superposées, qui forment le faux-plafond (3), et dans lesquelles sont pratiquées les ouvertures (2).

5. Système de climatisation selon la revendication 4, **caractérisé en ce que** la modification de la taille des ouvertures (2) est réalisée par déplacement d'une grille (30) par rapport à l'autre (40).

6. Système de climatisation selon la revendication 3, **caractérisé en ce que** la modification de la taille des ouvertures (2) est réalisée au moyen d'un diaphragme (60).

7. Système de climatisation selon l'une des revendications 3 à 6, **caractérisé en ce que** la modification de la taille des ouvertures (2) est effectuée de manière sélective.

8. Système de climatisation selon l'une des revendications 3 à 7, **caractérisé en ce que** la modification de la taille des ouvertures (2) est effectuée par groupement d'ouvertures.

9. Système de climatisation selon la revendication 8, **caractérisé en ce que** chaque groupement comprend un ensemble d'au moins une ouverture (2).

10. Système de climatisation selon l'une des revendications 8 ou 9, caractérisé en ce les ouvertures (2) d'un même groupement sont adjacentes.

11. Système de climatisation selon l'une des revendications 8 à 10, **caractérisé en ce que** chaque groupement définit une zone (50) du plafond (4a).

12. Système de climatisation selon l'une des revendications 1 à 11, **caractérisé en ce qu'**il comprend en outre des moyens de blocage en position des moyens de réglage (30, 40).

13. Système de climatisation selon la revendication 12, **caractérisé en ce que** les moyens de blocage sont des molettes.

14. Système de climatisation selon l'une des revendications 1 à 13, **caractérisé en ce qu'**il comprend en outre des moyens de récupération (20) de l'air insufflé.

15. Système de climatisation selon la revendication 14, **caractérisé en ce que** les moyens de récupération (20) sont destinés à être placés en partie basse de la pièce (1).

16. Système de climatisation selon l'une des revendications 14 ou 15, **caractérisé en ce que** les moyens de récupération (20) sont destinés à être placés dans une paroi latérale (4b) de la pièce (1).

17. Système de climatisation selon l'une des revendications 14 à 16, **caractérisé en ce que** les moyens de récupération (20) de l'air comprennent des filtres à air pour filtrer l'air récupéré.

18. Système de climatisation selon l'une des revendications 14 à 17, **caractérisé en ce que** des moyens de détection d'incendie sont placés au niveau des moyens de récupération (20) de l'air.

19. Système de climatisation selon l'une des revendications 1 à 18, **caractérisé en ce qu'**il comprend en outre des moyens de gestion de l'humidité de la pièce.

20. Système de climatisation selon l'une des revendications 1 à 19, **caractérisé en ce que** les moyens de réglage (30, 40) sont contrôlés manuellement.

21. Système de climatisation selon l'une des revendications 1 à 20, **caractérisé en ce que** les moyens de réglage (30, 40, 60) sont contrôlés par des moyens de commande en fonction d'une consigne de température.

22. Système de climatisation selon l'une des revendications 1 à 21, **caractérisé en ce que** l'air diffusé est mis en pression entre le plafond (4a) et le sous-plafond (3).

23. Système de climatisation selon l'une des revendications 1 à 22, **caractérisé en ce qu'**il comprend en outre au moins une centrale de climatisation.

24. Système de climatisation selon la revendication 23, **caractérisé en ce que** la centrale de climatisation est connectée en amont à des groupes froids.

25. Système de climatisation selon l'une des revendications 23 ou 24, **caractérisé en ce que** la centrale de climatisation est connectée en aval à une soufflerie (10).

26. Système de climatisation selon la revendication 25, **caractérisé en ce que** la soufflerie (10) envoie l'air entre le faux-plafond (3) et le plafond (4a).

27. Système de climatisation selon l'une des revendications 1 à 26, **caractérisé en ce qu'**il comprend en outre au moins une grille à ailettes (7).

28. Système de climatisation selon les revendications 25 et 27, prises en combinaison, **caractérisé en ce que** l'air envoyé par la soufflerie (10) est dévié par la grille à ailettes (7), de sorte que l'air soit réparti uniformément entre le plafond (4a) et le faux-plafond (3), et balaye toute la surface du faux-plafond (3).

29. Pièce (1) logeant du matériel informatique, **caractérisée en ce qu'**elle comprend un système de climatisation selon l'une des revendications 1 à 28.

30. Pièce (1) selon la revendication 29, **caractérisée en ce que** des chemins de câble (60) sont placés au niveau du plafond (4a).

31. Pièce (1) selon l'une des revendications 29 ou 30, **caractérisée en ce que** des chemins de câble (70) sont placés sous le faux-plafond (3).

32. Pièce selon l'une des revendications 29 à 31, **caractérisée en ce qu'**elle comprend un chemin de câble dédié à chaque élément parmi le groupe suivant : les courants forts, les courants faibles, et les réseaux de fibres optiques.

## Patentansprüche

1. Klimatisierungssystem eines Raums (1), umfassend Mittel (2) zur Verteilung von Luft in dem Raum (1) und Mittel (30, 40, 60) zur Regulierung der Verteilung der eingeblasenen Luft, die imstande sind, die Verteilung der Luft in dem Raum räumlich zu modulieren,
**dadurch gekennzeichnet, dass** die Mittel (2; 30, 40, 60) dazu bestimmt sind, in einer Zwischendecke (3) beabstandet von der Decke (4a) des Raums (1) platziert zu sein und dass die Mittel (2) zur Verteilung von Luft in die Zwischendecke (3) eingearbeitete Öffnungen sind.

2. Klimatisierungssystem nach Anspruch 1, **dadurch gekennzeichnet, dass** die Öffnungen (2) eine längliche, kreisförmige oder rechteckige Geometrie haben.

3. Klimatisierungssystem nach einem der Ansprüche 1 oder 2, **dadurch gekennzeichnet, dass** die räumliche Modulation durch die Mittel (30, 40, 60) zur Regulierung des verteilten Luftstroms durch Änderung der Größe der Öffnungen (2) erfolgt.

4. Klimatisierungssystem nach einem der Ansprüche 1 bis 3, **dadurch gekennzeichnet, dass** die Regulierungsmittel mindestens zwei übereinandergelagerte Gitter (30, 40) umfassen, welche die Zwischendecke (3) bilden, und in denen die Öffnungen (2) eingearbeitet sind.

5. Klimatisierungssystem nach Anspruch 4, **dadurch gekennzeichnet, dass** die Änderung der Größe der Öffnungen (2) durch Verlagern eines Gitters (30) in Bezug auf das andere (40) durchgeführt wird.

6. Klimatisierungssystem nach Anspruch 3, **dadurch gekennzeichnet, dass** die Änderung der Größe der Öffnungen (2) mittels einer Blende (60) durchgeführt wird.

7. Klimatisierungssystem nach einem der Ansprüche 3 bis 6, **dadurch gekennzeichnet, dass** die Änderung der Größe der Öffnungen (2) selektiv durchgeführt wird.

8. Klimatisierungssystem nach einem der Ansprüche 3 bis 7, **dadurch gekennzeichnet, dass** die Änderung der Größe der Öffnungen (2) durch Öffnungsgruppierungen durchgeführt wird.

9. Klimatisierungssystem nach Anspruch 8, **dadurch gekennzeichnet, dass** jede Gruppierung eine Gruppe mit mindestens einer Öffnung (2) umfasst.

10. Klimatisierungssystem nach einem der Ansprüche 8 oder 9, **dadurch gekennzeichnet, dass** die Öffnungen (2) einer selben Gruppierung benachbart sind.

11. Klimatisierungssystem nach einem der Ansprüche 8 bis 10, **dadurch gekennzeichnet, dass** jede Gruppierung eine Zone (50) der Decke (4a) definiert.

12. Klimatisierungssystem nach einem der Ansprüche 1 bis 11, **dadurch gekennzeichnet, dass** es ferner Blockiermittel der Position der Regulierungsmittel (30, 40) umfasst.

13. Klimatisierungssystem nach Anspruch 12, **dadurch gekennzeichnet, dass** die Blockiermittel Rädchen sind.

14. Klimatisierungssystem nach einem der Ansprüche 1 bis 13, **dadurch gekennzeichnet, dass** es ferner Rückgewinnungsmittel (20) der eingeblasenen Luft umfasst.

15. Klimatisierungssystem nach Anspruch 14, **dadurch gekennzeichnet, dass** die Rückgewinnungsmittel (20) dazu bestimmt sind, im unteren Teil des Raums (1) platziert zu sein.

16. Klimatisierungssystem nach einem der Ansprüche 14 oder 15, **dadurch gekennzeichnet, dass** die Rückgewinnungsmittel (20) dazu bestimmt sind, in einer Seitenwand (4b) des Raums (1) platziert zu sein.

17. Klimatisierungssystem nach einem der Ansprüche 14 bis 16, **dadurch gekennzeichnet, dass** die Rückgewinnungsmittel (20) der Luft Luftfilter umfassen, um die rückgewonnene Luft zu filtern.

18. Klimatisierungssystem nach einem der Ansprüche 14 bis 17, **dadurch gekennzeichnet, dass** Feuerdetektionsmittel im Bereich der Luftrückgewinnungsmittel (20) platziert sind.

19. Klimatisierungssystem nach einem der Ansprüche 1 bis 18, **dadurch gekennzeichnet, dass** es ferner Verwaltungsmittel der Feuchtigkeit des Raums umfasst.

20. Klimatisierungssystem nach einem der Ansprüche 1 bis 19, **dadurch gekennzeichnet, dass** die Regulierungsmittel (30, 40) manuell gesteuert werden.

21. Klimatisierungssystem nach einem der Ansprüche 1 bis 20, **dadurch gekennzeichnet, dass** die Regulierungsmittel (30, 40, 60) von Steuermitteln in Abhängigkeit von einem Temperatursollwert gesteuert werden.

22. Klimatisierungssystem nach einem der Ansprüche 1 bis 21, **dadurch gekennzeichnet, dass** die verteilte Luft zwischen der Decke (4a) der Unterdecke (3) druckbeaufschlagt wird.

23. Klimatisierungssystem nach einem der Ansprüche 1 bis 22, **dadurch gekennzeichnet, dass** es ferner mindestens eine Klimatisierungszentrale umfasst.

24. Klimatisierungssystem nach Anspruch 23, **dadurch gekennzeichnet, dass** die Klimatisierungszentrale den Kältegruppen vorgelagert geschaltet ist.

25. Klimatisierungssystem nach einem der Ansprüche 23 oder 24, **dadurch gekennzeichnet, dass** die Klimatisierungszentrale einem Gebläse (10) nachgelagert geschaltet ist.

26. Klimatisierungssystem nach Anspruch 25, **dadurch gekennzeichnet, dass** das Gebläse (10) Luft zwischen die Zwischendecke (3) und die Decke (4a) schickt.

27. Klimatisierungssystem nach einem der Ansprüche 1 bis 26, **dadurch gekennzeichnet, dass** es ferner mindestens ein Gitter mit Flügeln (7) umfasst.

28. Klimatisierungssystem nach den Ansprüchen 25 und 27, herangezogen in Kombination, **dadurch gekennzeichnet, dass** die von dem Gebläse (10) geschickte Luft von dem Gitter mit Flügeln (7) derart abgelenkt wird, dass die Luft gleichmäßig zwischen der Decke (4a) und der Zwischendecke (3) verteilt wird und die gesamte Oberfläche der Zwischendecke (3) bestreicht.

29. Raum (1), in dem IT-Material untergebracht ist, **dadurch gekennzeichnet, dass** er ein Klimatisierungssystem nach einem der Ansprüche 1 bis 28 umfasst.

30. Raum (1) nach Anspruch 29, **dadurch gekennzeichnet, dass** die Kabelrinnen (60) im Bereich der Decke (4a) platziert sind.

31. Raum (1) nach einem der Ansprüche 29 oder 30, **dadurch gekennzeichnet, dass** die Kabelrinnen (70) unter der Zwischendecke (3) platziert sind.

32. Raum nach einem der Ansprüche 29 bis 31, **dadurch gekennzeichnet, dass** er eine spezielle Kabelrinne für jedes Element aus der folgenden Gruppe: Starkstrom, Schwachstrom, und Glasfasernetze umfasst.

## Claims

1. A system for air-conditioning a room (1), comprising means (2) for diffusing air into the room (1) and means (30, 40, 60) for adjusting the diffusion of the blown air and adapted to spatially modulate the diffusion of air in the room,
**characterized in that** said means (2; 30, 40, 60) are intended to be placed in a false ceiling (3), away from the ceiling (4a) of the room (1), and **in that** the means (2) for diffusing the air are apertures made in the false ceiling (3).

2. The air-conditioning system according to claim 1, **characterized in that** the apertures (2) have an oblong, circular or rectangular geometry.

3. The air-conditioning system according to any one of claims 1 or 2, **characterized in that** the spatial modulation, through the means (30, 40, 60) for adjusting the diffused air flow, is performed by changing the size of the apertures (2).

4. The air-conditioning system according to any one of claims 1 to 3, **characterized in that** the adjusting means comprise at least two superimposed grids (30, 40) which form the false ceiling (3) and in which the apertures (2) are made.

5. The air-conditioning system according to claim 4, **characterized in that** the change in the size of the apertures (2) is achieved by moving one grid (30) relative to the other (40).

6. The air-conditioning system according to claim 3, **characterized in that** the change in the size of the apertures (2) is achieved by means of a diaphragm (60).

7. The air-conditioning system according to any one of claims 3 to 6, **characterized in that** the change in the size of the apertures (2) is achieved in a selective manner.

8. The air-conditioning system according to any one of claims 3 to 7, **characterized in that** the change in the size of the apertures (2) is achieved per array of apertures.

9. The air-conditioning system according to claim 8, **characterized in that** each array comprises a set of at least one aperture (2).

10. The air-conditioning system according to any one of claim 8 or 9, **characterized in that** the apertures (2) of the same array are adjacent.

11. The air-conditioning system according to any one of claims 8 to 10, **characterized in that** each array defines an area (50) of the ceiling (4a).

12. The air-conditioning system according to any one of claims 1 to 11, **characterized in that** it further comprises means for blocking in position the adjusting means (30, 40).

13. The air-conditioning system according to claim 12, **characterized in that** the blocking means are thumbwheels.

14. The air-conditioning system according to any one of claims 1 to 13, **characterized in that** it further comprises means (20) for recovering the injected air.

15. The air-conditioning system according to claim 14, **characterized in** what the recovery means (20) are intended to be placed in the lower part of the room (1) .

16. The air-conditioning system according to any one of claims 14 or 15, **characterized in that** the recovery means (20) are intended to be placed in a side wall (4b) of the room (1).

17. The air-conditioning system according to any one of claims 14 to 16, **characterized in that** the means (20) for recovering air comprise air filters to filter the recovered air.

18. The air-conditioning system according to any one of claims 14 to 17, **characterized in that** fire detection means are placed at the air recovery means (20) .

19. The air-conditioning system according to any one of claims 1 to 18, **characterized in that** it further comprises means for managing the moisture of the room.

20. The air-conditioning system according to any one of claims 1 to 19, **characterized in that** the adjusting means (30, 40) are manually controlled.

21. The air-conditioning system according to any one of claims 1 to 20, **characterized in that** the adjusting means (30, 40, 60) are controlled through control means according to a temperature set-point.

22. The air-conditioning system according to any one of claims 1 to 21, **characterized in that** the diffused air is pressurized between the ceiling (4a) and the sub-ceiling (3).

23. The air-conditioning system according to any one of claims 1 to 22, **characterized in that** it further comprises at least one central air-conditioning unit.

24. The air-conditioning system according to claim 23, **characterized in that** the central air-conditioning unit is connected upstream to cold groups.

25. The air-conditioning system according to any one of claims 23 or 24, **characterized in that** the central air-conditioning unit is connected downstream to a blower (10).

26. The air-conditioning system according to claim 25, characterized the blower (10) sends air between the false ceiling (3) and the ceiling (4a).

27. The air-conditioning system according to any one of claims 1 to 26, **characterized in that** it further comprises at least one finned grid (7).

28. The air-conditioning system according to claims 25 and 27, taken in combination, **characterized in that** the air sent by the blower (10) is diverted by the finned grid (7), so that the air is evenly distributed between the ceiling (4a) and the false ceiling (3), and sweeps the entire surface of the false ceiling (3).

29. A room (1) housing a computer equipment, **characterized in that** it comprises an air-conditioning system according to any one of claims 1 to 28.

30. The room (1) according to claim 29, **characterized in that** cable trays (60) are placed at the ceiling (4a).

31. The room (1) according to any one of claims 29 or 30, **characterized in that** cable trays (70) are placed under the false ceiling (3).

32. The room according to any one of claims 29 to 31, **characterized in that** it comprises a cable tray dedicated to each element among the following group: strong currents, weak currents, and fiber-optic networks.
